# EUROPEAN PATENT SPECIFICATION

(11) **EP 1 611 674 B1**
(45) Date of publication and mention of the grant of the patent: **08.11.2006**
(21) Application number: 04722613.9
(22) Date of filing: 23.03.2004
(51) Int. Cl.: H03D 13/00, H03L 7/089

(54) **LINEAR PHASE DETECTOR WITH MULTIPLEXED LATCHES**
LINEARER PHASENDETEKTOR MIT MULTIPLEXIERTEN VERRIEGELUNGSSCHALTUNGEN
DETECTEUR DE PHASE LINEAIRE DOTE DE BASCULES MULTIPLEXEES

(30) Priority: 28.03.2003 EP 03100829
(43) Date of publication of application: 04.01.2006
(73) Proprietor: Koninklijke Philips Electronics N.V., 5621 BA Eindhoven (NL)
(72) Inventor: SANDULEANU, Mihai, A., T., NL-5656 AA Eindhoven (NL)
(74) Representative: Eleveld, Koop Jan
(86) International application number: PCT/IB2004/050316
(87) International publication number: WO 2004/086605

(56) References cited:
- US-A- 5 619 171
- US-A- 5 712 580
- US-A1- 2001 031 028
- US-A1- 2002 135 400
- SAVOJ J ET AL: "Design of half-rate clock and data recovery circuits for optical communication systems" PROCEEDINGS OF THE 38TH. ANNUAL DESIGN AUTOMATION CONFERENCE. (DAC). LAS VEGAS, NV, JUNE 18 - 22, 2001, PROCEEDINGS OF THE DESIGN AUTOMATION CONFERENCE, NEW YORK, NY : ACM, US, vol. CONF. 38, 18 June 2001 (2001-06-18), pages 121-126, XP010552368 ISBN: 1-58113-297-2

## Description

The invention relates to a linear phase detector.

The invention also relates to a clock extractor and data regenerator and to an apparatus comprising such a clock extractor and data regenerator.

Such a linear phase detector is for example used in clock extractors and data regenerators of an open loop configuration or a closed loop configuration (like for example a Phase Locked Loop) and can for example be found in optical receivers. Said linear phase detector controls the phase of a clock (like for example a controlled oscillator) which needs to be synchronized with the incoming data. Thereto, said first control signal for example comprises an up signal or comprises an error signal, and said second control signal for example comprises a down signal or comprises a reference signal etc.

Such a clock extractor and data regenerator for example comprises said linear phase detector receiving data (at for example a data input) and followed by a filter, a controlled oscillator and a frequency divider fed back to (for example a clock input of) said linear phase detector. Said apparatus for example comprises an optical receiver for receiving an optical signal and comprising a converter for converting said optical signal into an electrical signal and comprising said clock extractor and data regenerator for extracting a clock signal and for regenerating a data signal from said electrical signal.

US-A-5,712,580 discloses a linear phase detector generating an up signal via a first D-flip-flop receiving an input signal from a second D-flip-flop situated in a feedback loop and generating a down signal via a third D-flip-flop receiving an input signal from said first D-flip-flop, based upon quadrature clock signals.

US-A-2001/031028 discloses a data clock recovery circuit comprises a controllable quadrature clock oscillator operating at half the data rate of data input to said circuit, and a phase detector logic having detector inputs coupled to the data input and having a detector output coupled to a frequency control input of the quadrature clock oscillator. The data clock recovery circuit further comprises a parallel arrangement of sampling devices, in particular flip-flops each having a clock input which is coupled to the controllable quadrature clock oscillator, a data input for the data input to said circuit, and a data output coupled to the phase detector. Accurate control of the phase of recovered data is possible with the present circuit, which is easy to integrate on a limited chip area and in a low power consuming way.

It is an object of the invention, inter alia, of providing a faster linear phase detector suitable for operation at higher frequencies.

By providing the linear phase detector according to the invention, as defined by claim 1, with parallel latches and multiplexers for multiplexing latch output signals, each pair of parallel latches will operate substantially simultaneously, with the multiplexer multiplexing the results from these operations. As a result, the delay from inputs of a pair of latches in the first circuit to an output of a multiplexer of the second circuit is reduced, which makes the linear phase detector faster.

It should be noted that each pair of parallel latches is defined to be parallel due to operating substantially simultaneously (substantially, due to possible different path lengths, different parasitic capacitors etc.) because of both receiving at least one same input signal (a data signal or a clock signal etc.) and/or because of both latches supplying their outputs signals to the same multiplexer. So, said pair of latches receive at least one same input signal and/or supply their output signals to the same multiplexer. Said latches are, in other words, multiplexed latches.

By supplying the data signal to the first latches of said first circuit and supplying the first multiplexer output signal to the second latches of said second circuit, the linear phase detector can be constructed efficiently in semiconductor technology.

By introducing said first logical circuitry and said second logical circuitry, like for example EXOR gates, a low cost, low complex and low power consuming, linear phase detector has been constructed.

It should further be noted that prior art non-linear phase detectors exist comprising multiplexed parallel latches. However, firstly, said prior art phase detectors are non-linear phase detectors, and secondly, in said non-linear prior art phase detectors both circuits are not coupled serially (with serially coupled meaning that the data signal is supplied to the first circuit and that the output signal of the first signal is supplied - as data signal - to the second circuit etc.).

A first embodiment of the linear phase detector according to the invention is defined by claim 2.

By introducing said third circuit and said fourth circuit, a fast linear phase detector has been constructed of which the combined result of the control signals after low pass filtering has become independent of the number of data transitions in the data signal. In other words, said combined result will, after low pass filtering, have an average value equal to zero, and the gain of the linear phase detector has become independent from the number of transitions in the data signal, which independency is advantageous.

A second embodiment of the linear phase detector according to the invention is defined by claim 3.

By supplying the second circuit output signal or the second multiplexer output signal to the third latches and supplying the third multiplexer output signal to the fourth latches, the linear phase detector having a data transition independent gain can be constructed efficiently in semiconductor technology.

A third embodiment of the linear phase detector according to the invention is defined by claim 4.

By introducing said third logical circuitry and said fourth logical circuitry, like for example EXOR gates, a low cost, low complex and low power consuming, linear phase detector having a data transition independent gain has been constructed.

A fourth embodiment of the linear phase detector according to the invention is defined by claim 5.

By coupling each one of said logical circuitry to an adder/subtracter, the combined result from this adder/subtracter (for example adding the first and fourth control signal and subtracting the second and third control signal) can be supplied to a charge pump and/or to a low pass filter.

Embodiments of the clock extractor and data regenerator according to the invention, of the method according to the invention, of the processor program product according to the invention and of the apparatus according to the invention correspond with the embodiments of the linear phase detector according to the invention.

The invention is based upon an insight, inter alia, that, generally, delay depends upon path lengths present between input to output and upon the number of operations performed between input and output, and is based upon a basic idea, inter alia, that, in a linear phase detector, a pair of parallel latches plus multiplexer per circuit will minimize this delay (minimum path length and minimum number of operations).

The invention solves the problem, inter alia, of providing a faster linear phase detector, and is advantageous, inter alia, in that such a faster linear phase detector can operate at higher frequencies (like for example at a frequency twice as high etc. compared to prior art detectors when using the same technology), whereby said linear phase detector can be further improved by introducing a data transition independent gain.

These and other aspects of the invention will be apparent from and elucidated with reference to the embodiments(s) described hereinafter.
Fig. 1 illustrates in block diagram form a linear phase detector according to the invention comprising two circuits,
Fig. 2 illustrates in block diagram form a timing diagram for said linear phase detector comprising two circuits,
Fig. 3 illustrates in block diagram form a linear phase detector according to the invention comprising four circuits, and
Fig. 4 illustrates in block diagram form a timing diagram for said linear phase detector comprising four circuits.

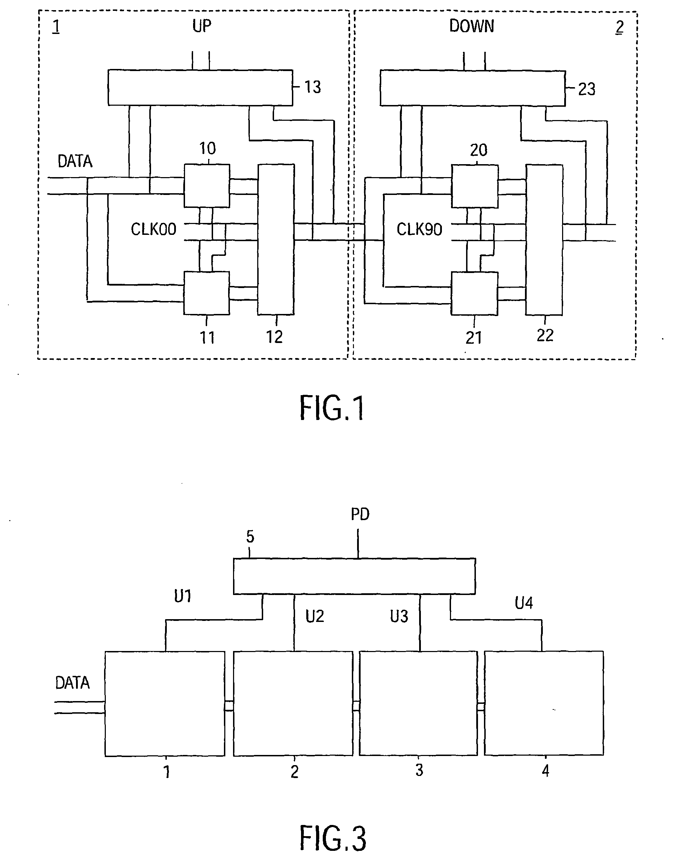

The linear phase detector according to the invention shown in Fig. 1 comprises a first circuit 1 with a latch 10 receiving at its data inputs (with the upper being the normal data input and with the lower being the inverted data input) the data signals and receiving at its respective clock inputs (with the left clock input being the normal clock input and with the right clock input being the inverted clock input) the clock signals at 00 degrees (first clock signal). A normal output (the upper output) of latch 10 is coupled to a first normal input of a multiplexer 12, and an inverted output (the lower output) of latch 10 is coupled to a first inverted input of multiplexer 12.

Circuit 1 further comprises a latch 11 receiving at its data inputs (with the upper being the normal data input and with the lower being the inverted data input) the data signals and receiving at its respective clock inputs (with the left clock input being the normal clock input and with the right clock input being the inverted clock input) the clock signals at 00 degrees via, compared to latch 10, exchanged connections. A normal output (the lower output) of latch 11 is coupled to a second inverted input of multiplexer 12, and an inverted output (the higher output) of latch 11 is coupled to a second normal input of multiplexer 12.

Multiplexer 12 receives at its control inputs (with the upper being the normal control input and with the lower being the inverted control input) said clock signals at 00 degrees via, compared to latch 10, non-exchanged connections.

Circuit 1 further comprises logical circuitry 13 like for example an EXOR gate receiving said data signals and the multiplexer output signals for generating a first control signal (UP signal).

The linear phase detector according to the invention shown in Fig. 1 further comprises a second circuit 2 with a latch 20 receiving at its data inputs (with the upper being the normal data input and with the lower being the inverted data input) the multiplexer output signals from the outputs of multiplexer 12 (with the upper being the normal output and with the lower being the inverted output) via non-exchanged connections and receiving at its respective clock inputs (with the left clock input being the normal clock input and with the right clock input being the inverted clock input) the clock signals at 90 degrees (second clock signal). A normal output (the upper output) of latch 20 is coupled to a first normal input of a multiplexer 22, and an inverted output (the lower output) of latch 20 is coupled to a first inverted input of multiplexer 22.

Circuit 2 further comprises a latch 21 receiving at its data inputs (with the upper being the normal data input and with the lower being the inverted data input) the data signals and receiving at its respective clock inputs (with the left clock input being the normal clock input and with the right clock input being the inverted clock input) the clock signals at 90 degrees via, compared to latch 20, exchanged connections. A normal output (the lower output) of latch 21 is coupled to a second inverted input of multiplexer 22, and an inverted output (the higher output) of latch 21 is coupled to a second normal input of multiplexer 22.

Multiplexer 22 receives at its control inputs (with the upper being the normal control input and with the lower being the inverted control input) said clock signals at 90 degrees via, compared to latch 20, non-exchanged connections.

Circuit 2 further comprises logical circuitry 23 like for example an EXOR gate receiving said multiplexer output signals from the outputs of multiplexers 12 and 22 for generating a second control signal (DOWN signal).

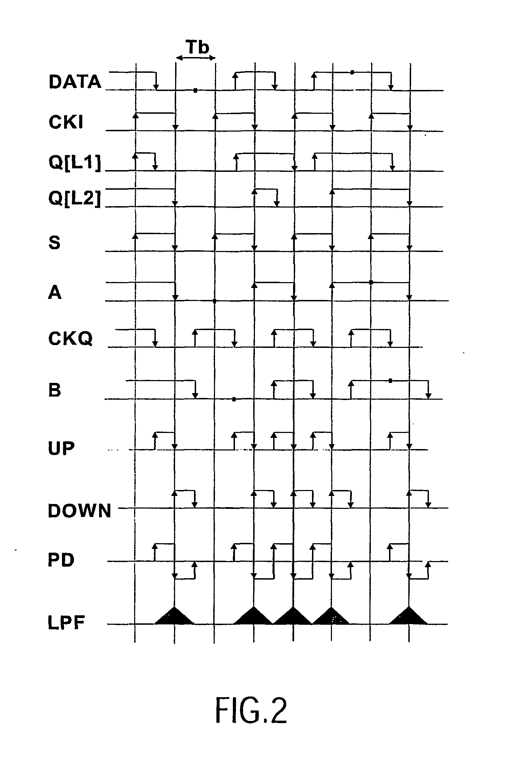

The timing diagram of the linear phase detector illustrated in Fig. I is shown in Fig. 2, with CKI being the first clock signal at 00 degrees, with Q(L1) being the output signal of latch 10, with Q(L2) being the output signal of latch 11, with S being the control input signal of multiplexer 12, with A indicating the output signal of multiplexer 12, with CKQ being the second clock signal at 90 degrees, with B indicating the output signal of multiplexer 22, with UP being the output signal of circuitry 13, with DOWN being the output signal of circuitry 23, with PD indicating the linear phase detector signal generated through combining said UP signal and said DOWN signal, and with LPF indicating said PD signal after being low pass filtered.

Due to LPF having an average value unequal to zero, said linear phase detector comprising two circuits 1,2 as illustrated in Fig. 1 will not have a gain which is independent from the number of transitions in the data signal.

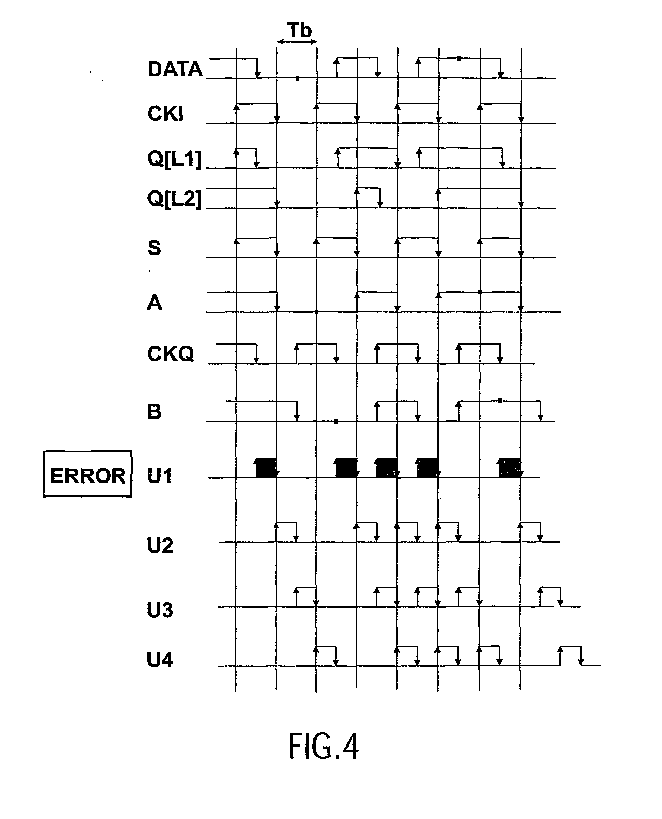

The linear phase detector according to the invention shown in Fig. 3 comprises four circuits 1, 2, 3 and 4, with circuits 1 and 2 corresponding with those shown in Fig. 1 and with the respective circuits 3 and 4 being equally built (and comprising the respective latches 30,31 and 40,41 and the respective multiplexers 32 and 42 and the respective logical circuitries 33 and 43 all not shown) and receiving the respective first (at 00 degrees) and second (at 90 degrees) clock signals, and with circuit 3 further receiving the output signal of circuit 2 (more precisely the output signal of multiplexer 22) and with circuit 4 receiving the output signal of circuit 3 (more precisely the output signal of the multiplexer 32 not shown). Logical circuitries 13, 23, 33 and 43 generate four control signals U1 (used to be UP), U2 (used to be DOWN), U3 and U4, which are supplied to an adder/subtracter 5 which adds for example U1 and U4 and subtracts U2 and U3 and which generates the signal PD.

The timing diagram of the linear phase detector illustrated in Fig. 3 is shown in Fig. 4, with CKI being the first clock signal at 00 degrees, with Q(L1) being the output signal of latch 10, with Q(L2) being the output signal of latch 11, with S being the control input signal of multiplexer 12, with A indicating the output signal of multiplexer 12, with CKQ being the second clock signal at 90 degrees, with B indicating the output signal of multiplexer 22, with U1 being the output signal of circuitry 13, with U2 being the output signal of circuitry 23, with U3 being the output signal of circuitry 33 and with U4 being the output signal of circuitry 43.

The signal PD is not shown but can be constructed through calculating U1 - U2 - U3 + U4 and indicates the linear phase detector signal generated through combining said U1, U2, U3 and U4. The signal LPF is not shown but can be constructed easily through integrating said PD signal (with integrating corresponding with low pass filtering). Due to LPF now having an average value equal to zero, said linear phase detector comprising four circuits 1,2,3,4 as illustrated in Fig. 3 will have a gain which is independent from the number of transitions in the data signal. This independency is very advantageous.

The phase detectors shown in Figs. 1 and 3 have double connections to fulfil the so-called balanced situation. But the invention is not limited to this balanced situation and can be used in the so-called unbalanced situation as well, with single connections.

The expression "for" in "for K" and "for L" does not exclude that other functions "for M" etc. are performed as well, simultaneously or not. The expressions "X coupled to Y" and "a coupling between X and Y" and "coupling/couples X and Y" etc. do not exclude that an element Z is in between X and Y. The expressions "P comprises Q" and "P comprising Q" etc. do not exclude that an element R is comprised/included as well.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

The invention is based upon an insight, inter alia, that, generally, delay depends upon path lengths present between input to output and upon the number of operations performed between input and output, and is based upon a basic idea, inter alia, that, in a linear phase detector, a pair of parallel latches plus multiplexer per circuit will minimize this delay (minimum path length and minimum number of operations).

The invention solves the problem, inter alia, of providing a faster linear phase detector, and is advantageous, inter alia, in that such a faster linear phase detector can operate at higher frequencies (like for example at a frequency twice as high etc. compared to prior art detectors when using the same technology), whereby said linear phase detector can be further improved by introducing a data transition independent gain.

## Claims

1. Linear phase detector comprising:
- a first circuit (1) coupled to for receive a first clock signal (CLK00) the first circuit (1) comprising first latches (10,11) for receiving a data signal (DATA), a first multiplexer for multiplexing output signals of said first latches to generate a first multiplexer output signal, first logical circuitry (13) for receiving said data signal (DATA), and said first multiplexer output signal for generating a first control signal (UP,U1), and
- a second circuit (2) coupled to for receive a second clock signal (CLK90), the second circuit (2) comprising second latches (20,21) for receiving the first multiplexer output signal, a second multiplexer (12,22) for multiplexing output signals of said second latches to generate a second multiplexer output signal, and
- second logical circuitry (23) for receiving said first multiplexer output signal and said second multiplexer output signal for generating a second control signal (DOWN,U2), and means (5) for generating a linear phase detector signal (PD) by combining said first and second control signals.

2. Linear phase detector according to claim 1, wherein said linear phase detector comprises at least a third circuit (3) for receiving said first clock signal (CLK00) and for generating at least one third control signal (U3) and at least a fourth circuit (4) for receiving said second clock signal (CLK90) and for generating at least one fourth control signal (U4), wherein each of said circuits (3,4) comprises at least two latches and at least one multiplexer for multiplexing latch output signals.

3. Linear phase detector according to claim 2, wherein third latches of said third circuit (3) receive at least one second circuit output signal, a third multiplexer of said third circuit (3) generating at least one third multiplexer output signal, which is inputted to fourth latches of said fourth circuit (4).

4. Linear phase detector according to claim 3, wherein third logical circuitry of said third circuit (3) receives said second circuit output signal and said third multiplexer output signal for generating said third control signal (U3), with fourth logical circuitry of said fourth circuit (4) receiving said third multiplexer output signal and at least one fourth multiplexer output signal.

5. Linear phase detector according to claim 4, wherein each one of said logical circuitry is coupled to an adder/subtracter (5).

6. Clock extractor and data regenerator comprising a linear phase detector as claimed in any of the preceding claims.

7. Apparatus comprising a clock extractor as claimed in claim 6.

## Patentansprüche

1. Linearer Phasendetektor, umfassend:
- einen ersten Schaltkreis (1), der so angeschlossen ist, dass er ein erstes Taktsignal (CLK00) empfangen kann, wobei der erste Schaltkreis (1) Folgendes umfasst: erste Zwischenspeicher (10, 11) zum Empfangen eines Datensignals (DATA), einen ersten Multiplexer zum Multiplexieren von Ausgangssignalen der ersten Zwischenspeicher zum Erzeugen eines Ausgangssignals des ersten Multiplexers, einen ersten logischen Schaltungsaufbau (13) zum Empfangen des Datensignals (DATA) und des Ausgangssignals des ersten Multiplexers zum Erzeugen eines ersten Steuersignals (UP, U1), und
- einen zweiten Schaltkreis (2), der so angeschlossen ist, dass er ein zweites Taktsignal (CLK90) empfangen kann, wobei der zweite Schaltkreis (2) zweite Zwischenspeicher (20, 21) zum Empfangen des Ausgangssignals des ersten Multiplexers und einen zweiten Multiplexer (12, 22) zum Multiplexen von Ausgangssignalen der zweiten Zwischenspeicher zum Erzeugen eines Ausgangssignals des zweiten Multiplexers umfasst, und
- einen zweiten logischen Schaltungsaufbau (23) zum Empfangen des Ausgangssignals des ersten Multiplexers und des Ausgangssignals des zweiten Multiplexers zum Erzeugen eines zweiten Steuersignals (DOWN, U2) sowie ein Mittel (5) zum Erzeugen eines Signals des linearen Phasendetektors (PD) durch Kombinieren des ersten und des zweiten Steuersignals.

2. Linearer Phasendetektor nach Anspruch 1, wobei der lineare Phasendetektor wenigstens einen dritten Schaltkreis (3) zum Empfangen des ersten Taktsignals (CLK00) und zum Erzeugen wenigstens eines dritten Steuersignals (U3) sowie wenigstens einen vierten Schaltkreis (4) zum Empfangen des zweiten Taktsignals (CLK90) und zum Erzeugen wenigstens eines vierten Steuersignals (U4) umfasst, wobei jeder der Schaltkreise (3, 4) wenigstens zwei Zwischenspeicher und wenigstens einen Multiplexer zum Multiplexieren von Zwischenspeicher-Ausgangssignalen umfasst.

3. Linearer Phasendetektor nach Anspruch 2, wobei dritte Zwischenspeicher des dritten Schaltkreises (3) wenigstens ein Ausgangssignal des zweiten Schaltkreises empfangen, wobei ein dritter Multiplexer des dritten Schaltkreises (3) wenigstens ein Ausgangssignal des dritten Multiplexers erzeugt, das in die vierten Zwischenspeicher des vierten Schaltkreises (4) eingespeist wird.

4. Linearer Phasendetektor nach Anspruch 3, wobei ein dritter logischer Schaltungsaufbau des dritten Schaltkreises (3) das Ausgangssignal des zweiten Schaltkreises und das Ausgangssignal des dritten Multiplexers zum Erzeugen des dritten Steuersignals (U3) empfängt, wobei ein vierter logischer Schaltungsaufbau des vierten Schaltkreises (4) das Ausgangssignal des dritten Multiplexers und wenigstens ein Ausgangssignal des vierten Multiplexers empfängt.

5. Linearer Phasendetektor nach Anspruch 4, wobei jede der logischen Schaltungsaufbauten an einen Addierer/Subtrahierer (5) angeschlossen ist.

6. Taktgewinnungsvorrichtung und Datenregenerator, die einen linearen Phasendetektor nach einem der vorangehenden Ansprüche umfassen.

7. Vorrichtung, die eine Taktgewinnungsvorrichtung nach Anspruch 6 umfasst.

## Revendications

1. Détecteur de phase linéaire comprenant:
- un premier circuit (1) qui est couplé de manière à recevoir un premier signal d'horloge (CLK00), le premier circuit (1) comprenant des premières bascules (10, 11) pour recevoir un signal de données (DATA), un premier multiplexeur pour multiplexer des signaux de sortie desdites premières bascules de manière à générer un premier signal de sortie du multiplexeur, des premiers circuits logiques (13) pour recevoir ledit signal de données (DATA) et ledit premier signal de sortie du multiplexeur pour générer un premier signal de commande (UP, U1), et
- un deuxième circuit (2) qui est couplé de manière à recevoir un deuxième signal d'horloge (CLK90), le deuxième circuit (2) comprenant des deuxièmes bascules (20, 21) pour recevoir le premier signal de sortie du multiplexeur, un deuxième multiplexeur (12, 22) pour multiplexer des signaux de sortie desdites deuxièmes bascules de manière à générer un deuxième signal de sortie du multiplexeur, et
- des deuxièmes circuits logiques (23) pour recevoir ledit premier signal de sortie du multiplexeur et ledit deuxième signal de sortie du multiplexeur de manière à générer un deuxième signal de commande (DOWN, U2), et des moyens (5) pour générer un signal (PD) du détecteur de phase linéaire par la combinaison desdits premier et deuxième signaux de commande.

2. Détecteur de phase linéaire selon la revendication 1, dans lequel ledit détecteur de phase linéaire comprend au moins un troisième circuit (3) pour recevoir ledit premier signal d'horloge (CLK00) et pour générer au moins un troisième signal de commande (U3) et au moins un quatrième circuit (4) pour recevoir ledit deuxième signal d'horloge (CLK90) et pour générer au moins un quatrième signal de commande (U4) dans lequel chacun desdits circuits (3, 4) comprend au moins deux bascules et au moins un multiplexeur pour multiplexer des signaux de sortie des bascules.

3. Détecteur de phase linéaire selon la revendication 2, dans lequel des troisièmes dudit troisième circuit reçoivent au moins un deuxième signal de sortie du circuit, un troisième multiplexeur dudit troisième circuit (3) générant au moins un troisième signal de sortie du multiplexeur qui est introduit dans des quatrièmes bascules dudit quatrième circuit (4).

4. Détecteur de phase linéaire selon la revendication 3, dans lequel des troisièmes circuits logiques dudit troisième circuit (3) reçoivent ledit deuxième signal de sortie du circuit et ledit troisième signal de sortie du multiplexeur pour générer ledit troisième signal de commande (U3), quatre circuits logiques dudit quatrième circuit (4) recevant ledit troisième signal de sortie du multiplexeur et au moins un quatrième signal de sortie du multiplexeur.

5. Détecteur de phase linéaire selon la revendication 4, dans lequel chacun desdits circuits logiques est couplé à un additionneur/soustracteur (5).

6. Extracteur d'horloge et régénérateur de données comprenant un détecteur de phase linéaire selon l'une quelconque des revendications précédentes 1 à 5.

7. Appareil comprenant un extracteur d'horloge selon la revendication 6.
